# EUROPEAN PATENT APPLICATION

(11) **EP 4 571 812 A1**
(43) Date of publication of application: **18.06.2025**
(21) Application number: 23852422.7
(22) Date of filing: 31.07.2023
(51) Int. Cl.: H01L 21/02

(54) **COMPOSITE SUBSTRATE FOR TRANSFERRING SIC SINGLE CRYSTAL, METHOD FOR MANUFACTURING COMPOSITE SUBSTRATE FOR TRANSFERRING SIC SINGLE CRYSTAL, AND METHOD FOR MANUFACTURING SIC BONDED SUBSTRATE**

(30) Priority: 10.08.2022 JP 2022128205
(71) Applicant: Sicoxs Corporation, Minato-ku Tokyo 1050004 (JP)
(72) Inventor: TERASHIMA, Akira, Tokyo 105-0004 (JP)
(74) Representative: TBK
(86) International application number: PCT/JP2023/027954
(87) International publication number: WO 2024/034450

(57) **Abstract**

Provided are: a composite substrate for transferring a SiC single crystal; a method for manufacturing the composite substrate for transferring a SiC single crystal; and a method for manufacturing a SiC bonded substrate, in which warpage in a SiC single-crystalline substrate repeatedly used in a process for manufacturing a SiC bonded substrate is improved such that errors in conveying the SiC single-crystalline substrate or a problem of not being able to hold the SiC single-crystalline substrates on a processing table can be suppressed, the SiC single-crystalline substrate can be held on the processing table using an electrostatic chuck during a surface activation step or a bonding step, and the occurrence of bonding defects can be suppressed.

A composite substrate for transferring a SiC single crystal includes a SiC single-crystalline substrate and a first SiC polycrystalline substrate having a volume resistivity of 10 Ω·cm or less, in which one surface of the SiC single-crystalline substrate is directly bonded to one surface of the first SiC polycrystalline substrate by covalent bonds.

## Description

### Technical Field

The present invention relates to a technical field of a SiC bonded substrate including a SiC single-crystalline thin film and a SiC polycrystalline substrate which is manufactured by bonding a SiC single-crystalline substrate and a SiC polycrystalline substrate used for a semiconductor device or the like and separating a SiC single-crystalline thin film from a surface of the SiC single-crystalline substrate, and particularly to a composite substrate for transferring a SiC single crystal, a method for manufacturing the composite substrate for transferring a SiC single crystal, and a method for manufacturing a SiC bonded substrate.

### Background Art

Silicon carbide (hereinafter, referred to as "SiC" in some cases) has a band gap that is about three times larger than that of silicon (hereinafter, referred to as "Si" in some cases) (about 3.8 eV for 4H-SiC, about 3.1 eV for 6H-SiC, vs. about 1.1 eV for Si) and a high thermal conductivity (about 5 W/cm·K for SiC vs. about 1.5 W/cm·K for Si), and thus in recent years, single-crystal SiC has begun to be used as a substrate material for power device applications.

Usually, a SiC single-crystalline substrate is manufactured by a gas phase method called a sublimation recrystallization method (improved Rayleigh method) (see, for example, Non Patent Literature 1), and processed to a desired diameter and thickness.

The improved Rayleigh method is a production method in which a SiC solid raw material (usually powder) is heated and sublimated at a high temperature (2,400°C or higher), silicon atoms and carbon atoms sublimated in an inert gas atmosphere are transported by diffusion as vapor at 2,400°C, and supersaturated and recrystallized on a seed crystal placed at a temperature lower than that of the raw material to grow a massive single crystal.

However, since this method has a very high process temperature of 2,400°C or higher, it is very difficult to control the temperature and convection of crystal growth and to control crystal defects. Therefore, a SiC single-crystalline substrate produced by this method has a large number of crystal defects called micropipes and other crystal defects (stacking defects and the like), and it is difficult to manufacture a high-quality single-crystalline substrate that can withstand electronic device applications with high yield.

In order to manufacture a high-quality single-crystalline substrate, various devices have been made. For example, a SiC single-crystalline substrate can be produced by using a CVD method. However, although the SiC single crystal produced by this method has high quality with few crystal defects that can be used for electronic devices, the SiC single crystal is expensive, and devices using expensive SiC single crystals are also expensive, which hinders the spread of SiC single-crystalline substrates.

Therefore, there is provided a technique of manufacturing a SiC bonded substrate having both low cost (support substrate portion) and high quality (SiC portion) by using a high-quality SiC single crystal only in a device formation layer portion and fixing the SiC single crystal to a support substrate (material having strength, heat resistance, and cleanliness that can withstand device manufacturing processes: for example, SiC polycrystal) by a bonding method not involving formation of an oxide film at a bonded interface (see, for example, Patent Literature 1).

A manufacturing process of the SiC bonded substrate will be specifically described. First, in a planarization step, the surface of a SiC polycrystalline support substrate is planarized by mechanical polishing such as grinding, polishing, or lapping. In the planarization step, the surface of the SiC single-crystalline substrate is also planarized in the same manner, but since crystal grains having different crystal orientations do not exist in the substrate plane in the SiC single-crystalline substrate, it is possible to further planarize the surface of the substrate using chemical mechanical polishing after the mechanical polishing. Next, in an ion implantation step, hydrogen ions are implanted from the surface of the SiC single-crystalline substrate after planarization. As a result, a hydrogen ion implantation layer is formed at a predetermined depth from the surface of the SiC single-crystalline substrate. Separation is performed at this portion by a separation technique by ablation of hydrogen atoms described later. The depth of the hydrogen ion implantation layer can be controlled by the energy of hydrogen ions to be ion-implanted, but is usually in a range of 0.5 to 1.0 µm.

The surfaces of the planarized polycrystalline SiC and the SiC single-crystalline substrate are bonded to each other using a surface activation method. The polycrystalline SiC and the SiC single-crystalline substrate bonded to each other are heated. As a result, the SiC single-crystalline substrate is broken and separated in the hydrogen ion implantation layer. A SiC bonded substrate is obtained in a state where a high-quality SiC single-crystalline thin film having a thickness of 0.5 to 1.0 µm is transferred to and bonded to the surface of the SiC polycrystalline substrate as a support substrate.

The thickness is reduced by about 1 µm due to peeling off of the hydrogen ion implanted layer. But as long as the SiC single crystal substrate is thick enough to be used for transfer, the surface of the substrate on the side to be bonded again is subjected to flat processing, and the SiC single-crystalline substrate is repeatedly provided for manufacturing a bonded substrate.

When a SiC bonded substrate is produced using the manufacturing method described in Patent Literature 1, the repeatedly used SiC single-crystalline substrate is gradually thinned every time bonding and separation are performed. When the thickness of the SiC single-crystalline substrate is reduced, the warpage of the SiC single-crystalline substrate increases. In particular, the warpage of the SiC single-crystalline substrate after hydrogen ion implantation remarkably increases due to the stress inside the substrate caused by the formation of the hydrogen ion implantation layer in the ion implantation step, and errors in conveying the SiC single-crystalline substrate or a problem of not being able to hold the SiC single-crystalline substrates on a processing table occurs. In a surface activation step and a bonding step, since the inside of the apparatus is in a vacuum state, it is not possible to hold the SiC single-crystalline substrate on a processing table by vacuum suction, and bonding defects such as non-uniform bonding between the SiC polycrystalline substrate and the SiC single-crystalline substrate easily occur.

### Citation List

### Patent Literature

Patent Literature 1: JP 2015-015401 A

### Non Patent Literature

Non Patent Literature 1: Yu. M. Tairov and V. F. Tsvetkov: J. of Cryst. Growth 43(1978)209

### Summary of Invention

### Technical Problem

Therefore, an object of the present invention is to provide a composite substrate for transferring a SiC single crystal, a method for manufacturing the composite substrate for transferring a SiC single crystal, and a method for manufacturing a SiC bonded substrate, in which warpage in a SiC single-crystalline substrate repeatedly used in a process for manufacturing a SiC bonded substrate is improved such that errors in conveying the SiC single-crystalline substrate or a problem of not being able to hold the SiC single-crystalline substrates on a processing table can be suppressed, the SiC single-crystalline substrate can be held on the processing table using an electrostatic chuck during a surface activation step or a bonding step, and the occurrence of bonding defects can be suppressed.

### Solution to Problem

In order to solve the above problems, a composite substrate for transferring a SiC single crystal of the present invention is a composite substrate for transferring a SiC single crystal including a SiC single-crystalline substrate and a first SiC polycrystalline substrate having a volume resistivity of 10 Ω·cm or less, in which one surface of the SiC single-crystalline substrate is directly bonded to one surface of the first SiC polycrystalline substrate by covalent bonds.

The first SiC polycrystalline substrate may have a wafer shape, and a maximum value of a contour line of a circumference of the first SiC polycrystalline substrate may be identical to a contour line of a circumference of a bonding surface between the SiC single-crystalline substrate and the first SiC polycrystalline substrate.

In order to solve the above problems, a method for manufacturing the composite substrate for transferring a SiC single crystal of the present invention is a method for manufacturing the composite substrate for transferring a SiC single crystal, including: a first activation step of irradiating a first bonding target surface of the SiC single-crystalline substrate and a bonding target surface of the first SiC polycrystalline substrate with a fast atomic beam to activate these bonding target surfaces; and a first normal temperature bonding step of bonding the first bonding target surface of the SiC single-crystalline substrate and the bonding target surface of the first SiC polycrystalline substrate to each other at normal temperature such that these bonding target surfaces are directly bonded to each other by covalent bonds, after the first activation step.

The method may include a side surface polishing step of polishing a side surface of the first SiC polycrystalline substrate to remove a side surface of the SiC single-crystalline substrate, a side surface of the first SiC polycrystalline substrate, and a recess formed by a contour of a circumference of a bonding surface between the SiC single-crystalline substrate and the first SiC polycrystalline substrate, after the first normal temperature bonding step.

In order to solve the above problems, a method for manufacturing a SiC bonded substrate of the present invention is a method for manufacturing a SiC bonded substrate, the method including: a hydrogen ion implantation layer forming step of implanting hydrogen ions into a second bonding target surface of the SiC single-crystalline substrate in the composite substrate for transferring a SiC single crystal of the present invention to form a hydrogen ion implantation layer inside the SiC single-crystalline substrate; a second activation step of irradiating the second bonding target surface of the SiC single-crystalline substrate and a bonding target surface of a second SiC polycrystalline substrate with a fast atomic beam to activate these bonding target surfaces; a second normal temperature bonding step of bonding the second bonding target surface of the SiC single-crystalline substrate and the bonding target surface of the second SiC polycrystalline substrate at normal temperature such that these bonding target surfaces are directly bonded to each other by covalent bonds, after the second activation step; and a peeling step of peeling the SiC single-crystalline substrate along the hydrogen ion implantation layer to transfer a SiC single-crystalline thin film to the second SiC polycrystalline substrate, after the second normal temperature bonding step, in which the composite substrate for transferring a SiC single crystal and the second SiC polycrystalline substrate are held by an electrostatic chuck, the SiC bonded substrate including the SiC single-crystalline thin film on the second SiC polycrystalline substrate.

The method for manufacturing a SiC bonded substrate of the present invention is a method repeatedly using the composite substrate for transferring a SiC single crystal after the peeling step to manufacture a plurality of the SiC bonded substrates, in which the hydrogen ion implantation layer forming step, the second activation step, the second normal temperature bonding step, and the peeling step may be repeated until a thickness of the SiC single-crystalline substrate of the composite substrate for transferring a SiC single crystal is less than 140 µm.

### Advantageous Effects of Invention

According to the present invention, it is possible to provide a composite substrate for transferring a SiC single crystal, a method for manufacturing the composite substrate for transferring a SiC single crystal, and a method for manufacturing a SiC bonded substrate, in which warpage in a SiC single-crystalline substrate repeatedly used in a process for manufacturing a SiC bonded substrate is improved such that errors in conveying the SiC single-crystalline substrate or a problem of not being able to hold the SiC single-crystalline substrates on a processing table can be suppressed, the SiC single-crystalline substrate can be held on the processing table using an electrostatic chuck during a surface activation step or a bonding step, and the occurrence of bonding defects can be suppressed.

### Brief Description of Drawings

Fig. 1 is a flowchart illustrating an example of a method for manufacturing a composite substrate for transferring a SiC single crystal and a method for manufacturing a SiC bonded substrate of the present invention.
Fig. 2 is a view illustrating an example of a first activation step (S1) in the present invention.
Fig. 3 is a view illustrating an example of a first normal temperature bonding step (S2) in the present invention.
Fig. 4 is a view illustrating an example of a side surface polishing step (S3) in the present invention and schematic side views of composite substrates for transferring a SiC single crystal of the present invention.
Fig. 5 is a view illustrating an example of a hydrogen ion implantation layer forming step (S4) in the present invention.
Fig. 6 is a view illustrating an example of a second activation step (S5) in the present invention.
Fig. 7 is a view illustrating an example of a second normal temperature bonding step (S6) in the present invention.
Fig. 8 is a view illustrating an example of a peeling step (S7) in the present invention.
Fig. 9 is a view illustrating an example of a second bonding target surface polishing step (S8) in the present invention.

### Description of Embodiments

Hereinafter, an example of an embodiment of the present invention will be described with reference to the drawings.

### [Composite Substrate for Transferring SiC Single Crystal]

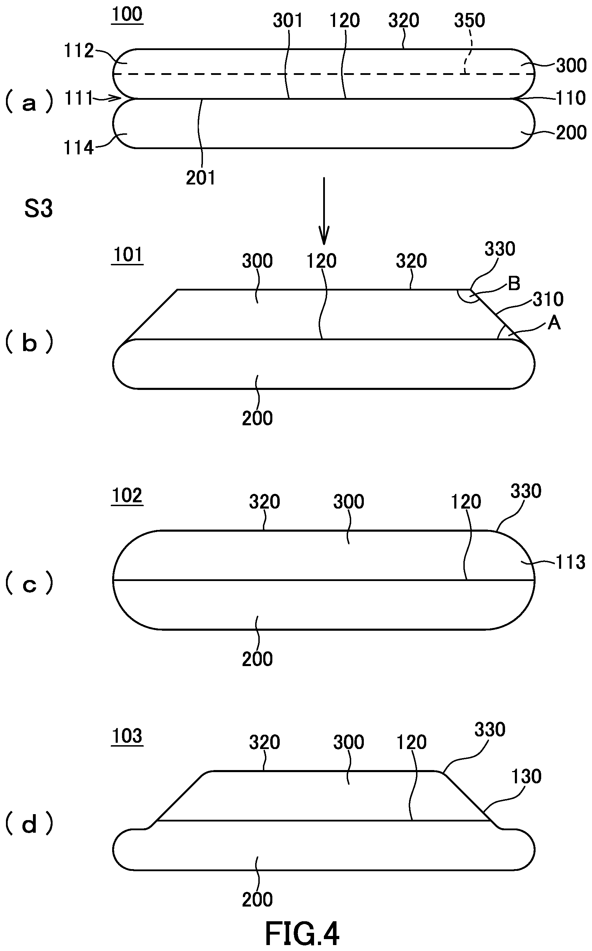

A composite substrate for transferring a SiC single crystal of the present invention is a substrate that can be used for manufacturing a SiC bonded substrate, and is a substrate to be a base of a SiC single-crystalline thin film to be transferred to a SiC polycrystalline substrate. Fig. 4 illustrates side views of composite substrates 100 to 103 for SiC single crystal transfer of the present invention.

The composite substrate 100 for transferring a SiC single crystal includes a SiC single-crystalline substrate 200 and a first SiC polycrystalline substrate 300, and one surface 201 of the SiC single-crystalline substrate 200 is directly bonded to the entire surface of one surface 301 of the first SiC polycrystalline substrate 300 by covalent bonds.

### <SiC Single-Crystalline Substrate 200>

As the SiC single-crystalline substrate 200, for example, a 4H-SiC single-crystalline substrate manufactured by a sublimation method can be used. The shape of the SiC single-crystalline substrate 200 is, for example, a substantially disk shape including an orientation flat, and a substrate having a diameter of 4 to 8 inches can be used. Note that the shape is not limited to a disk shape (wafer shape), and may be a polygonal shape.

When the thickness of the SiC single-crystalline substrate 200 decreases, the warpage of the SiC single-crystalline substrate 200 increases, and as a result, the composite substrate 100 for transferring a SiC single crystal warps, so that there may occur a conveyance error in which the composite substrate 100 for transferring a SiC single crystal cannot be conveyed, and a problem of, for example, not being able to hold the composite substrate 100 for transferring a SiC single crystal on a processing table or not being able to sandwich the composite substrate 100 for transferring a SiC single crystal. Therefore, the entire thickness of the composite substrate 100 for transferring a SiC single crystal is preferably set to 300 µm or more in which warpage is allowable, and when the thickness is 300 µm or more, the composite substrate 100 for transferring a SiC single crystal can be conveyed and held on a processing table. Note that the initial thickness of the SiC single-crystalline substrate 200 is generally 300 µm to 600 µm.

Note that it is preferable to use the SiC single-crystalline substrate 200 in which chamfering of a corner of a side surface, double-sided lapping, polishing, cleaning, and the like are performed in advance before being bonded to the first SiC polycrystalline substrate 300 to eliminate a process-damaged layer or waviness on the surface of the SiC single-crystalline substrate 200.

### <First SiC Polycrystalline Substrate 300>

The first SiC polycrystalline substrate 300 is a substrate that can reinforce the SiC single-crystalline substrate 200 by being directly bonded to the SiC single-crystalline substrate 200 by covalent bonds. By reinforcing the SiC single-crystalline substrate 200, for example, even when the SiC single-crystalline substrate 200 is repeatedly used and peeled off by a hydrogen ion implantation layer to reduce the thickness, it is possible to suppress the warpage of the SiC single-crystalline substrate 200 in a hydrogen ion implantation layer forming step and the like described later, and holding, conveying, and the like of the SiC single-crystalline substrate 200 can be achieved by suppressing the warpage.

In consideration of a difference in thermal expansion from the SiC single-crystalline substrate 200, heat resistance, high rigidity, durability for repeated use, and the like, as the first SiC polycrystalline substrate 300, for example, a 3C-SiC polycrystalline substrate obtained by forming a SiC polycrystalline film by a chemical vapor deposition method can be used. The shape of the first SiC polycrystalline substrate 300 may be substantially the same as that of the SiC single-crystalline substrate 200 and is, for example, a substantially disk shape including an orientation flat, and a substrate having a diameter of 4 to 8 inches can be used. Note that the shape is not limited to a disk shape, and may be a polygonal shape.

If the thickness of the first SiC polycrystalline substrate 300 is too thin, the reinforcing effect of alleviating the warpage of the SiC single-crystalline substrate 200 is weakened, and as a result, the composite substrate 100 for transferring a SiC single crystal warps, so that there may occur a conveyance error in which the composite substrate 100 for transferring a SiC single crystal cannot be conveyed, and a problem of, for example, not being able to hold the composite substrate 100 for transferring a SiC single crystal on a processing table or not being able to sandwich the composite substrate 100 for transferring a SiC single crystal. Therefore, by setting the entire thickness of the composite substrate 100 for transferring a SiC single crystal to 300 µm or more in which warpage is allowable, the composite substrate 100 for transferring a SiC single crystal can be conveyed and held on a processing table. When the thickness of the first SiC polycrystalline substrate 300 is set to 300 µm or more, preferably 350 µm or more, holding, conveying, and the like of the composite substrate 100 for transferring a SiC single crystal become easier. Note that the upper limit of the thickness of the first SiC polycrystalline substrate 300 does not affect the solution of the problem of the present invention, and is not particularly limited, but is generally 500 µm.

The volume resistivity of the first SiC polycrystalline substrate 300 is 10 Ω·cm or less. The first SiC polycrystalline substrate 300 is bonded as an auxiliary substrate to the SiC single-crystalline substrate 200, and may be repeatedly subjected to bonding, peeling, polishing, cleaning, and the like during the manufacturing process of the SiC bonded substrate to be repeatedly used for bonding the SiC bonded substrate. Therefore, when the insulating property of the first SiC polycrystalline substrate 300 is high, polishing debris, polishing powder, or the like generated during polishing of the composite substrate 100 for transferring a SiC single crystal adheres to the first SiC polycrystalline substrate 300, and is carried into a second normal temperature bonding step described later, which is likely to cause a bonding defect between the SiC single-crystalline substrate 200 and a second SiC polycrystalline substrate 700. By setting the volume resistivity of the first SiC polycrystalline substrate 300 to 10 Ω·cm or less, it is possible to suppress bonding defects caused by polishing debris, polishing powder, or the like.

In the second activation step and the normal temperature bonding step, since the inside of the apparatus is in a vacuum state, it is not possible to hold a substrate to be treated on a processing table by a vacuum suction method, and it is necessary to hold the substrate to be treated by a method other than the vacuum suction method. In the present application, an electrostatic chuck method is used. Since the electrostatic chuck applies a potential difference between a dielectric film and a substrate, and holds the substrate by electrostatic force of charges charged between the dielectric film and the wafer, when the resistance of the substrate is high, problems arise in that a discharge time constant of charges increases and the substrate is not easily peeled off. This causes a decrease in manufacturing processing capacity of the apparatus in the mass production process of substrates. Therefore, in order to use the electrostatic chuck method, conductivity is required for a substrate to be held. In the case of the composite substrate 100 for transferring a SiC single crystal, since the first SiC polycrystalline substrate 300 is in contact with the electrostatic chuck, the first SiC polycrystalline substrate 300 having conductivity is used. That is, the volume resistivity of the first SiC polycrystalline substrate 300 is set to 10 Ω·cm or less. As a result, the first SiC polycrystalline substrate 300 can be easily detached from the electrostatic chuck, and there is no need to particularly devise the labor of applying a conductive substance to the substrate and the internal electrode structure of the electrostatic chuck. Since there is no need to use a mechanical chuck method, a dust source called a mechanical chuck can be removed from the method for manufacturing a SiC bonded substrate.

Note that, the lower limit of the volume resistivity of the first SiC polycrystalline substrate 300 does not affect the solution of the problem of the present invention, and is not particularly limited, but is 1 Ω·cm as a guide. Although the volume resistivity of the first SiC polycrystalline substrate 300 varies depending on the temperature of the substrate at the time of measurement, in the present specification, the volume resistivity is a value when the temperature of the first SiC polycrystalline substrate 300 is 25°C.

It is preferable to use the first SiC polycrystalline substrate 300 in which chamfering of a corner of a side surface, double-sided lapping, polishing, cleaning, and the like are performed in advance before being bonded to the SiC single-crystalline substrate 200 to eliminate a process-damaged layer or waviness on the surface of the first SiC polycrystalline substrate 300.

The side surfaces of the SiC single-crystalline substrate 200 and the first SiC polycrystalline substrate 300 are generally chamfered in advance before bonding, and when the composite substrate 100 for transferring a SiC single crystal is viewed from a side surface direction, as illustrated in Fig. 4(a), the composite substrate 100 for transferring a SiC single crystal is recessed at a contour 110 of the bonding surface, and the diameter of the contour 110 of the composite substrate 100 for transferring a SiC single crystal is smaller than the diameter of a contour line 350 of a circumference described later on the side surface of the composite substrate 100 for transferring a SiC single crystal. The composite substrate 100 for transferring a SiC single crystal may be repeatedly subjected to bonding, peeling, polishing, cleaning, and the like during the manufacturing process of the SiC bonded substrate to be repeatedly used for bonding the SiC bonded substrate. Therefore, in a shape in which the side surface of the composite substrate 100 for transferring a SiC single crystal is recessed at the contour 110 of the bonding surface to be reduced in a groove shape, that is, in a state where there is a recess 111 formed by the contour 110 of the circumference of the bonding surface between the SiC single-crystalline substrate 200 and the first SiC polycrystalline substrate 300, polishing debris, polishing powder, or the like of the substrate generated during polishing tend to remain in the groove-shaped recess 111 even when the composite substrate 100 for transferring a SiC single crystal is cleaned, and can be a dust source in the process of manufacturing the SiC bonded substrate.

The side surface 112 of the first SiC polycrystalline substrate 300 may be polished by performing a side surface polishing step (S3) described later, and a slope 310 may be formed on the outer peripheral portion of the first SiC polycrystalline substrate 300, for example, as illustrated in the composite substrate 101 for transferring a SiC single crystal of Fig. 4(b). Since the recess 111 is eliminated by forming the slope 310, the dust source can be removed. An angle A of a gradient formed by a bonding surface 120 of the composite substrate 101 for transferring a SiC single crystal and the slope 310 is set to 30° to 60°, preferably 45° so as not to weaken the strength of the first SiC polycrystalline substrate 300. An angle B of a gradient formed by a back side surface 320 of the first SiC polycrystalline substrate 300 and the slope 310 is set to an obtuse angle, so that it is possible to prevent the first SiC polycrystalline substrate 300 from being chipped at an end 330 formed by the back side surface 320 of the first SiC polycrystalline substrate 300 and the slope 310.

The shape in which the recess 111 is eliminated is not limited to the composite substrate 101 for transferring a SiC single crystal, and examples thereof include the composite substrate 102 for transferring a SiC single crystal illustrated in Fig. 4(c) and the composite substrate 103 for transferring a SiC single crystal illustrated in Fig. 4(d). In the composite substrate 102 for transferring a SiC single crystal, a side surface 113 is chamfered so that the SiC single-crystalline substrate 200 and the first SiC polycrystalline substrate 300 are combined into a semicircle. The composite substrate 103 for transferring a SiC single crystal has a side surface shape similar to that of the composite substrate 101 for transferring a SiC single crystal, but in the composite substrate 103 for transferring a SiC single crystal, only the side surface 112 of the first SiC polycrystalline substrate 300 is polished to form the slope 310, whereas in the composite substrate 103 for transferring a SiC single crystal, the entire side surface 112 of the first SiC polycrystalline substrate 300 and a part of the side surface 114 of the SiC single-crystalline substrate 200 are polished to form the slope 130.

In the case of the composite substrate 100 for transferring a SiC single crystal, neither the contour line of the circumference of the back side surface 320 nor the contour line of the circumference of the bonding surface 120 is the maximum value of the contour line of the circumference of the first SiC polycrystalline substrate 300, and such a maximum value is the contour line 350 of the circumference (dotted line in Fig. 4(a)) between the back side surface 320 and the bonding surface 120 and equidistant from any of these surfaces. In this manner, when the contour line of the circumference of the bonding surface 120 is not such a maximum value, the recess 111 is formed.

On the other hand, what is common to the composite substrates 101, 102, and 103 for transferring a SiC single crystal is that the contour line of the circumference of the back side surface 320 of the first SiC polycrystalline substrate 300 is the minimum value of the contour line of the circumference of the first SiC polycrystalline substrate 300, and the contour line of the circumference of the bonding surface 120 of the first SiC polycrystalline substrate 300 is the maximum value of the contour line of the circumference of the first SiC polycrystalline substrate 300.

That is, since the contour line of the maximum value of the circumference of the first SiC polycrystalline substrate 300 is the same as the contour line of the circumference of the bonding surface 120 between the SiC single-crystalline substrate 200 and the first SiC polycrystalline substrate 300, the recess 111 does not exist in the composite substrates for transferring a SiC single crystal.

The end 330 of the back side surface 320 of the first SiC polycrystalline substrate 300 may be chamfered so that the first SiC polycrystalline substrate 300 is not chipped due to impact or the like.

### [Method for Manufacturing Composite Substrate for Transferring SiC Single Crystal]

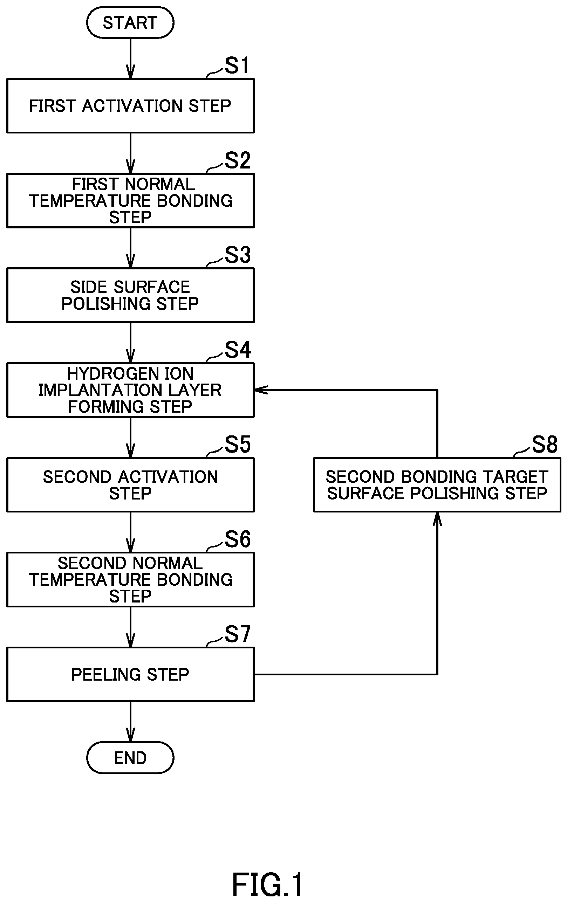

Next, a method for manufacturing the composite substrates 100 to 103 for transferring a SiC single crystal of the present invention will be described. The composite substrate 100 for transferring a SiC single crystal can be manufactured by a first activation step (S1) and a first normal temperature bonding step (S2) of Fig. 1.

### <First Activation Step (S1)>

The first activation step is a step of irradiating a first bonding target surface 260 of the SiC single-crystalline substrate 200 and a bonding target surface 360 of the first SiC polycrystalline substrate 300 with a fast atomic beam to activate these bonding target surfaces.

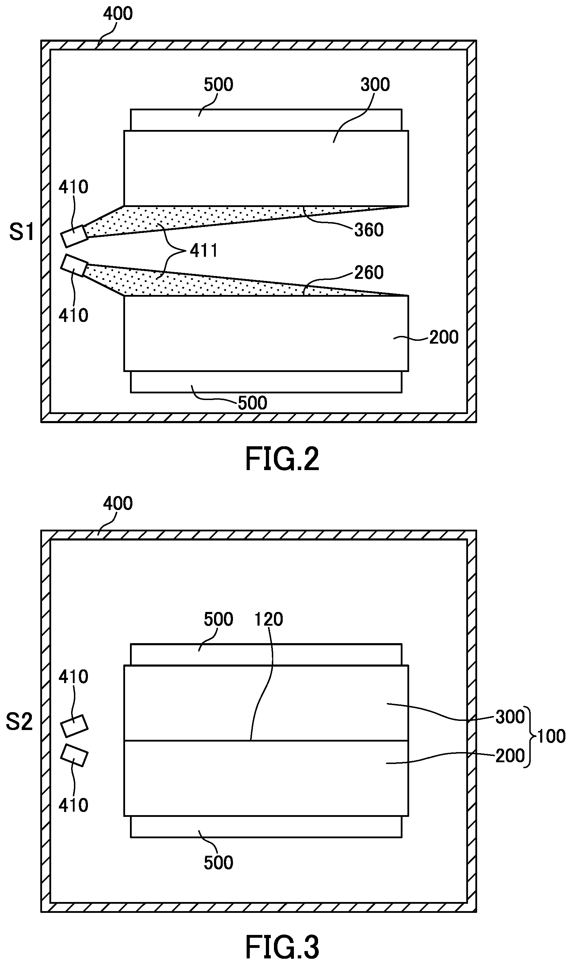

As illustrated in Fig. 2, the SiC single-crystalline substrate 200 and the first SiC polycrystalline substrate 300 are sucked by electrostatic chucks 500 and set in a chamber 400. Next, the electrostatic chucks 500 are moved to align relative positions of the SiC single-crystalline substrate 200 and the first SiC polycrystalline substrate 300. The alignment is performed so that the SiC single-crystalline substrate 200 and the first SiC polycrystalline substrate 300 can be bonded in contact with each other in a correct positional relationship in a first normal temperature bonding step described later. Next, the inside of the chamber 400 is brought into a vacuum state. The degree of vacuum in the chamber 400 may be, for example, about 1×10⁻⁴ to 1×10⁻⁷ Pa.

Next, the bonding target surface 360 of the first SiC polycrystalline substrate 300 and the first bonding target surface 260 of the SiC single-crystalline substrate 200 are irradiated with a neutral element beam 411 of argon (Ar) as a fast atomic beam using fast atomic beam guns (FAB guns) 410. The entire surface of the first bonding target surface 260 and the entire surface of the bonding target surface 360 are uniformly irradiated with the neutral element beam 411 of argon (Ar). By causing atoms or molecules to collide with the surface of the substrate using the FAB guns, it is possible to remove the oxide and the adsorption layer on the surface of the substrate by the sputtering phenomenon, and thus, it is possible to remove the oxide film and the adsorption layer on the first bonding target surface 260 and the bonding target surface 360 to expose bonds. A state where the oxide film and the adsorption layer are removed to expose the bond is referred to as an active state. Since the irradiation of the neutral element beam 411 is a process performed in vacuum, the first bonding target surface 260 and the bonding target surface 360 can maintain an active state without being oxidized or the like. Here, as the fast atomic beam, an argon (Ar) ion beam or an argon (Ar) neutral atomic beam is used.

Note that it is preferable to use the SiC single-crystalline substrate 200 and the first SiC polycrystalline substrate 300 in which chamfering of a corner of a side surface, double-sided lapping, polishing, cleaning, and the like are performed in advance before the first activation step to eliminate a process-damaged layer or waviness on the surface of the first SiC polycrystalline substrate 300.

### <First Normal Temperature Bonding Step (S2)>

The first normal temperature bonding step is a step of bonding the first bonding target surface 260 of the SiC single-crystalline substrate 200 and the bonding target surface 360 of the first SiC polycrystalline substrate 300 to each other at normal temperature after the first activation step, in which the first bonding target surface 260 and the bonding target surface 360 are directly bonded to each other by covalent bonds. For direct bonding, a method of bonding by applying heat to a substrate, such as a bonding method of exposing a substrate to a condition such as 2 hours at 1100°C or a bonding method of welding a substrate at a temperature of 2000°C or higher, but in the method of applying heat, production efficiency is poor, and it is difficult to align substrate positions at the time of heating with high accuracy. When the heating temperature exceeds 2000°C, silicon in SiC escapes and becomes a void, which deteriorates conductivity. In the present invention, by employing a method of bonding at normal temperature as the bonding method, productivity can be improved, conductivity can be maintained, and the bonding positions of the SiC single-crystalline substrate 200 and the first SiC polycrystalline substrate 300 can be aligned with high accuracy.

As illustrated in Fig. 3, by moving the electrostatic chucks 500, the first bonding target surface 260 of the SiC single-crystalline substrate 200 and the bonding target surface 360 of the first SiC polycrystalline substrate 300 are brought into contact with each other in a vacuum state in the chamber 400 and are brought into pressure contact with each other. The bonds existing on the first bonding target surface 260 and the bonding target surface 360 in the active state are connected to each other, and the SiC single-crystalline substrate 200 and the first SiC polycrystalline substrate 300 can be bonded. As a result, the composite substrate 100 for transferring a SiC single crystal having a structure in which the SiC single-crystalline substrate 200 and the first SiC polycrystalline substrate 300 are bonded is formed. Note that the normal temperature is 20°C to 30°C.

### <Side Surface Polishing Step (S3)>

In the present invention, the method may include the side surface polishing step, and this step is a step of polishing the side surface 112 of the first SiC polycrystalline substrate 300 to remove the side surface 114 of the SiC single-crystalline substrate 200, the side surface 112 of the first SiC polycrystalline substrate 300, and the recess 111 formed by the contour 110 of the circumference of the bonding surface 120 between the SiC single-crystalline substrate 200 and the first SiC polycrystalline substrate 300, after the first normal temperature bonding step.

The side surface polishing step is preferably performed after the first SiC polycrystalline substrate 300 is bonded to the SiC single-crystalline substrate 200, that is, after the first normal temperature bonding step. When the side surface 112 of the first SiC polycrystalline substrate 300 before bonding is polished, the angle A (Fig. 4(b)) becomes an acute angle, and the first SiC polycrystalline substrate 300 may be chipped due to some impact or contact with something before bonding with the SiC single-crystalline substrate 200.

In this step, the side surface of the composite substrate 100 for transferring a SiC single crystal (Fig. 4(a)) may be polished so as to have the shape of the composite substrates 101 to 103 for transferring a SiC single crystal (Figs. 4(b) to 4(d)).

Specifically, the side surface can be polished using a beveling machine or a grinding device. For example, the side surface 112 of the first SiC polycrystalline substrate 300 can be polished by any one of the following methods (1) to (3). (1) In a state where the wafer-shaped composite substrate 100 for transferring a SiC single crystal is rotated about the center thereof as a rotation axis, grinding is performed by bringing a grindstone of a grindstone wheel that rotates similarly into contact with the side surface 112 of the first SiC polycrystalline substrate 300. (2) The side surface 112 of the wafer-shaped composite substrate 100 for transferring a SiC single crystal in a rotated state is brought into contact with a non-rotating grindstone for grinding. (3) A grindstone of a grindstone wheel that rotates and revolves around the bonded substrate is brought into contact with the side surface 112 of the composite substrate 100 for transferring a SiC single crystal for grinding.

### [Method for Manufacturing SiC Bonded Substrate]

Next, a method for manufacturing a SiC bonded substrate of the present invention will be described. A SiC bonded substrate can be manufactured by a hydrogen ion implantation layer forming step (S4), a second activation step (S5), a second normal temperature bonding step (S6), and a peeling step (S7) of Fig. 1. Note that, in the following description, an example in which the composite substrate 100 for transferring a SiC single crystal is used is described, but a SiC bonded substrate can also be manufactured by using the composite substrates 101 to 103 for transferring a SiC single crystal.

### <Hydrogen Ion Implantation Layer Forming Step (S4)>

The hydrogen ion implantation layer forming step is a step of implanting hydrogen ions into a second bonding target surface 270 of the SiC single-crystalline substrate 200 in the composite substrate 100 for transferring a SiC single crystal to form a hydrogen ion implantation layer 600 inside the SiC single-crystalline substrate 200.

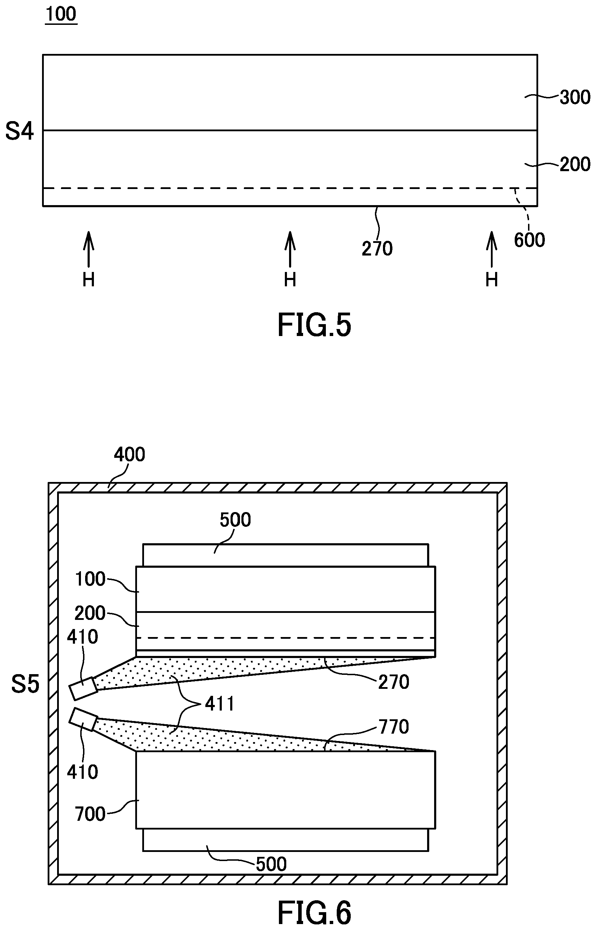

When hydrogen ions are implanted into the SiC single-crystalline substrate 200, the hydrogen ions reach a depth corresponding to incident energy and are distributed at a high concentration. As a result, as illustrated in the schematic side view of the composite substrate 100 for transferring a SiC single crystal of Fig. 5, the hydrogen ion implantation layer 600 indicated by the dotted line is formed at a predetermined depth from the second bonding target surface 270. For example, the hydrogen ion implantation layer 600 is formed at a position of about 0.5 to 1.0 µm in depth from the second bonding target surface 270.

### <Second Activation Step (S5)>

The second activation step is a step of irradiating the second bonding target surface 270 of the SiC single-crystalline substrate 200 and a bonding target surface 770 of the second SiC polycrystalline substrate 700 with a fast atomic beam to activate these bonding target surfaces.

The procedure of the basic step is similar to that of the first activation step. As illustrated in Fig. 6, the composite substrate 100 for transferring a SiC single crystal and the second SiC polycrystalline substrate 700 are sucked by the electrostatic chucks 500 and set in the chamber 400. Next, the electrostatic chucks 500 are moved to align relative positions of the composite substrate 100 for transferring a SiC single crystal and the second SiC polycrystalline substrate 700. The alignment is performed such that both substrates can be in contact with each other in a correct positional relationship in a second normal temperature bonding step described later. Next, the inside of the chamber 400 is brought into a vacuum state. The degree of vacuum in the chamber 400 may be, for example, about 1×10⁻⁴ to 1×10⁻⁷ Pa.

Next, the second bonding target surface 270 of the SiC single-crystalline substrate 200 and the bonding target surface 770 of the second SiC polycrystalline substrate 700 are irradiated with the neutral element beam 411 of argon (Ar) as a fast atomic beam using the fast atomic beam guns (FAB guns) 410. The entire surface of the second bonding target surface 270 and the entire surface of the bonding target surface 770 are uniformly irradiated with the neutral element beam 411 of argon (Ar). By causing atoms or molecules to collide with the surface of the substrate using the FAB guns, it is possible to remove the oxide and the adsorption layer on the surface of the substrate by the sputtering phenomenon, and thus, it is possible to remove the oxide film and the adsorption layer on the second bonding target surface 270 and the bonding target surface 770 to expose bonds. A state where the oxide film and the adsorption layer are removed to expose the bond is referred to as an active state. Since the irradiation of the neutral element beam 411 is a process performed in vacuum, the second bonding target surface 270 and the bonding target surface 770 can maintain an active state without being oxidized or the like.

### <Second SiC Polycrystalline Substrate 700>

The second SiC polycrystalline substrate 700 is a support substrate in the SiC bonded substrate. As the second SiC polycrystalline substrate 700, for example, a 3C-SiC polycrystalline substrate obtained by forming a SiC polycrystalline film by a chemical vapor deposition method can be used. The shape of the second SiC polycrystalline substrate 700 may be substantially the same as that of the composite substrate 100 for transferring a SiC single crystal and is, for example, a substantially disk shape including an orientation flat, and a substrate having a diameter of 4 to 8 inches can be used. Note that the shape is not limited to a disk shape, and may be a polygonal shape.

The thickness of the second SiC polycrystalline substrate 700 may be any thickness as long as it is a general thickness as a support substrate of the SiC bonded substrate, and is, for example, 300 µm to 500 µm. The volume resistivity of the second SiC polycrystalline substrate 700 may be 0.005 to 10 Ω·cm in consideration of conductivity, or a SiC polycrystalline substrate having a volume resistivity of 10⁵ Ω·cm or more, which is a general volume resistivity of SiC, may be used.

Note that it is preferable to use the second SiC polycrystalline substrate 700 in which chamfering of a corner of a side surface, double-sided lapping, polishing, cleaning, and the like are performed in advance before the second activation step to eliminate a process-damaged layer or waviness on the surface of the second SiC polycrystalline substrate 700.

### <Second Normal Temperature Bonding Step (S6)>

The second normal temperature bonding step is a step of bonding the second bonding target surface 270 of the SiC single-crystalline substrate 200 and the bonding target surface 770 of the second SiC polycrystalline substrate 700 to each other at normal temperature after the second activation step, in which the second bonding target surface 270 and the bonding target surface 770 are directly bonded to each other by covalent bonds.

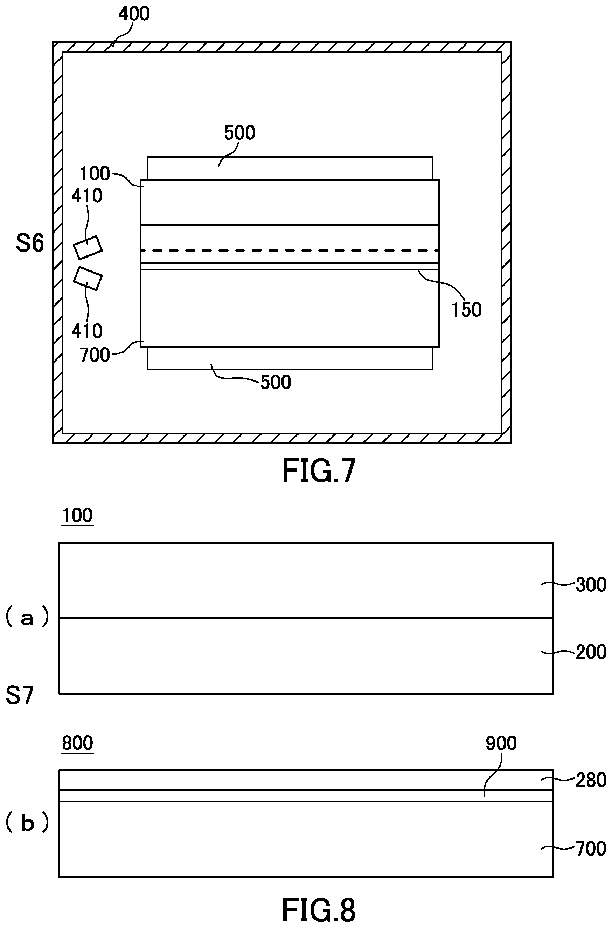

The procedure of the basic step is similar to that of the first normal temperature bonding step. As illustrated in Fig. 7, by moving the electrostatic chucks 500, the second bonding target surface 270 of the SiC single-crystalline substrate 200 and the bonding target surface 770 of the second SiC polycrystalline substrate 700 are brought into contact with each other in a vacuum state in the chamber 400. The bonds existing on the second bonding target surface 270 and the bonding target surface 770 in the active state are connected to each other, and the composite substrate 100 for transferring a SiC single crystal and the second SiC polycrystalline substrate 700 can be bonded. Note that the normal temperature is 20°C to 30°C.

### <Peeling Step (S7)>

The peeling step is a step of peeling the SiC single-crystalline substrate 200 along the hydrogen ion implantation layer 600 to transfer a SiC single-crystalline thin film 280 to the second SiC polycrystalline substrate 700, after the second normal temperature bonding step.

In the peeling step, heat is applied to the SiC single-crystalline substrate 200 to form a microbubble layer in the hydrogen ion implantation layer 600, and the SiC single-crystalline thin film 280 having a thickness of about 0.5 to 1.0 µm is transferred to the second SiC polycrystalline substrate 700 using the microbubble layer as a peeling surface to form a SiC bonded substrate 800.

Specifically, the composite substrate 100 for transferring a SiC single crystal and the second SiC polycrystalline substrate 700 bonded to each other are heated to about 800°C or higher. The atmosphere for peeling may be at least one atmosphere of an inert gas such as argon (Ar) or nitrogen (N), and vacuum. The peeling step may be performed using rapid thermal annealing (RTA) or a furnace. As a result, the SiC single-crystalline substrate 200 can be separated by the hydrogen ion implantation layer 600. Fig. 8 illustrates a schematic side view of the composite substrate 100 for transferring a SiC single crystal after the peeling step (Fig. 8(a)), and a schematic side view of the SiC bonded substrate 800 (Fig. 8(b)).

The method for manufacturing a SiC bonded substrate of the present invention may be a method repeatedly using the composite substrate 100 for transferring a SiC single crystal after the peeling step to manufacture a plurality of the SiC bonded substrates 800, in which the hydrogen ion implantation layer forming step, the second activation step, the second normal temperature bonding step, and the peeling step may be repeated until the thickness of the composite substrate 100 for transferring a SiC single crystal including the SiC single-crystalline substrate 200 is less than 300 µm.

### <Second Bonding Target Surface Polishing Step (S8)>

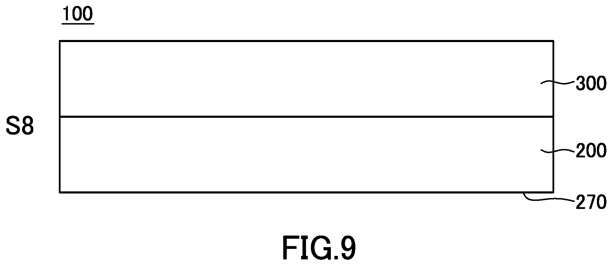

When the composite substrate 100 for transferring a SiC single crystal after the peeling step is repeatedly used, the second bonding target surface polishing step may be performed. This step is a step of mirror-polishing the second bonding target surface 270 (Fig. 9) after the peeling step and before the hydrogen ion implantation layer forming step. The mirror polishing may be performed by mechanical polishing or the like for grinding or polishing the second bonding target surface 270, or may be performed by a CMP method.

In the steps S4 to S8 of the present invention, the composite substrate 100 for transferring a SiC single crystal, the second SiC polycrystalline substrate 700, and the SiC bonded substrate 800 may be held by electrostatic chucks. Note that, for example, since the second activation step (S5) and the second normal temperature bonding step (S6) are performed under a reduced pressure condition (about 1×10⁻⁴ to 1×10⁻⁷ Pa), vacuum chuck cannot be used to hold the composite substrate 100 for transferring a SiC single crystal, the second SiC polycrystalline substrate 700, and the SiC bonded substrate 800. For this reason, a mechanical chuck method or an electrostatic chuck method is used, but in the mechanical chuck method, a local stress is applied to these substrates in holding, and not only these substrates cannot be held flat, but also cracks and scratches are generated on these substrates because these substrates are repeatedly used, so that there is a possibility that these cracks and scratches become a dust source. Therefore, in order to avoid the occurrence of cracks and scratches, it is preferable to use an electrostatic chuck method capable of holding these substrates on the entire surface without stress for conveying and holding these substrates.

### Examples

Next, the present invention will be described more specifically with reference to Examples, but the present invention is not limited to the following Examples at all.

### [Manufacturing of Composite Substrate for Transferring SiC Single Crystal]

### <Substrate Used>

### (SiC Single-Crystalline Substrate 200)

As the SiC single-crystalline substrate 200, a SiC single-crystalline substrate of a 4H polytype having conductivity with a diameter of 150 mm, a thickness of 350 µm, and a main surface orientation of the substrate of <0001> was prepared in which the side surface was chamfered into an R shape, and both surfaces of the first bonding target surface 260 and its opposite surface of the substrate were mirror-polished and cleaned.

### (First SiC Polycrystalline Substrate A (Volume Resistivity 3 Ω·cm))

As the first SiC polycrystalline substrate 300, a cubic first SiC polycrystalline substrate A having conductivity with a diameter of 150 mm and a thickness of 350 µm was prepared in which the side surface was chamfered into an R shape, and both surfaces of the bonding target surface 360 and its opposite surface of the substrate were mirror-polished and cleaned. The volume resistivity of the first SiC polycrystalline substrate A is 3 Ω·cm at 25°C.

### (First SiC Polycrystalline Substrate B (Volume Resistivity 10⁵ Ω·cm))

For comparison of the first SiC polycrystalline substrate 300, a first SiC polycrystalline substrate B having a volume resistivity of 100 Ω·cm at 25°C was prepared. The first SiC polycrystalline substrate B is a cubic SiC polycrystalline substrate with a diameter of 150 mm and a thickness of 350 µm in which the side surface was chamfered into an R shape, and both surfaces of the substrate were mirror-polished and cleaned, similarly to the first SiC polycrystalline substrate A.

### <Example 1>

A plurality of composite substrates 100 for transferring a SiC single crystal having a thickness of 700 µm of Example 1 were manufactured by performing the following first activation step (S1) and first normal temperature bonding step (S2) using the SiC single-crystalline substrate 200 and the first SiC polycrystalline substrate A as the first SiC polycrystalline substrate 300.

### (First Activation Step (S1))

As illustrated in Fig. 2, the SiC single-crystalline substrate 200 and the first SiC polycrystalline substrate 300 were sucked by the electrostatic chucks 500 and set in the chamber 400. Next, the electrostatic chucks 500 were moved to align relative positions of the SiC single-crystalline substrate 200 and the first SiC polycrystalline substrate 300 such that these substrates could be in contact with each other in the correct positional relationship in the first normal temperature bonding step. Next, the inside of the chamber 400 was brought into a vacuum state of 2×10⁻⁶ Pa.

Then, in the vacuum state, the entire surface of the first bonding target surface 260 and the entire surface of the bonding target surface 360 were uniformly irradiated with the neutral atomic beam 411 of argon using the FAB guns 410 on the bonding target surface 360 of the first SiC polycrystalline substrate 300 and the first bonding target surface 260 of the SiC single-crystalline substrate 200, and the oxide film and the adsorption layer of the first bonding target surface 260 and the bonding target surface 360 were removed to expose bonds, thereby obtaining the active state.

### (First Normal Temperature Bonding Step (S2))

As illustrated in Fig. 3, by moving the electrostatic chucks 500 in the chamber 400 while maintaining the vacuum state at normal temperature, the first bonding target surface 260 of the SiC single-crystalline substrate 200 and the bonding target surface 360 of the first SiC polycrystalline substrate 300 were brought into contact with each other in a vacuum state in the chamber 400 to be directly bonded by covalent bonds, thereby manufacturing the composite substrate 100 for transferring a SiC single crystal.

### <Example 2>

The composite substrate 100 for transferring a SiC single crystal of Example 1 was further subjected to the following side surface polishing step to remove the recess 111, thereby manufacturing a plurality of composite substrates 101 for transferring a SiC single crystal having a thickness of 700 µm of Example 2.

### (Side Surface Polishing Step (S3))

The side surface of the first SiC polycrystalline substrate 300 of the composite substrate 100 for transferring a SiC single crystal of Example 1 was polished by a beveling machine using diamond electrodeposition grindstones with a count of #400 and #800 to form the slope 310 having the angle A of 45°.

### <Comparative Example 1>

A plurality of composite substrates for transferring a SiC single crystal having a thickness of 700 µm of Comparative Example 1 were manufactured by the same method as in Example 1, except that the SiC polycrystalline substrate B was used instead of the SiC polycrystalline substrate A. Note that, in the first activation step, the first normal temperature bonding step, the second activation step, and the second normal temperature bonding step, mechanical chucks were used instead of the electrostatic chucks.

### <Comparative Example 2>

A plurality of SiC single-crystalline substrates 200 themselves were prepared without bonding any of the SiC polycrystalline substrates A and B to the SiC single-crystalline substrate 200, and were used for the following manufacturing of the SiC bonded substrate.

### [Manufacturing of SiC Bonded Substrate]

The following steps S4 to S9 were performed for each of the composite substrate 100 for transferring a SiC single crystal of Example 1, the composite substrate 101 for transferring a SiC single crystal of Example 2, composite substrate for transferring a SiC single crystal of Comparative Example 1, and the SiC single-crystalline substrate 200 of Comparative Example 2 to bond the following second SiC polycrystalline substrate 700, thereby manufacturing a SiC bonded substrate.

### (Second SiC Polycrystalline Substrate 700 (Volume Resistivity 3 Ω·cm))

As the second SiC polycrystalline substrate 700, the same substrate as the first SiC polycrystalline substrate A was used. That is, the substrate is a cubic SiC polycrystalline substrate having conductivity with a diameter of 150 mm and a thickness of 350 µm, in which the side surface was chamfered into an R shape, and both surfaces of the substrate were mirror-polished and cleaned, and the volume resistivity is 3 Ω·cm at 25°C.

### (Hydrogen Ion Implantation Layer Forming Step (S4))

Hydrogen ions were implanted into the second bonding target surface 270 of the SiC single-crystalline substrate 200 in the composite substrate 100 for transferring a SiC single crystal of Example 1 to form the hydrogen ion implantation layer 600 at a position of 0.8 µm in depth from the second bonding target surface 270.

A hydrogen ion implantation layer was also formed at a position of 0.8 µm in depth in the same manner for the composite substrate 101 for transferring a SiC single crystal of Example 2, the composite substrate for transferring a SiC single crystal of Comparative Example 1, and the SiC single-crystalline substrate 200 of Comparative Example 2.

### (Second Activation Step (S5))

As illustrated in Fig. 7, the composite substrate 100 for transferring a SiC single crystal and the second SiC polycrystalline substrate 700 were sucked by the electrostatic chucks 500 and set in the chamber 400. Next, the electrostatic chucks 500 were moved to align relative positions of the composite substrate 100 for transferring a SiC single crystal and the second SiC polycrystalline substrate 700 such that both of these substrates could be in contact with each other in the correct positional relationship in the second normal temperature bonding step. Next, the inside of the chamber 400 was brought into a vacuum state of 2×10⁻⁶ Pa.

Next, the entire surface of the second bonding target surface 270 and the entire surface of the bonding target surface 770 were uniformly irradiated with the neutral atomic beam 411 of argon using the FAB guns 410 on the second bonding target surface 270 of the SiC single-crystalline substrate 200 and the bonding target surface 770 of the second SiC polycrystalline substrate 700, and the oxide film and the adsorption layer of the second bonding target surface 270 and the bonding target surface 770 were removed to expose bonds, thereby obtaining the active state.

The second activation step was also performed in the same manner for the composite substrate 101 for transferring a SiC single crystal of Example 2, the composite substrate for transferring a SiC single crystal of Comparative Example 1, and the SiC single-crystalline substrate 200 of Comparative Example 2.

### (Second Normal Temperature Bonding Step (S6))

As illustrated in Fig. 7, by moving the electrostatic chucks 500 in the chamber 400 while maintaining the vacuum state at normal temperature, the second bonding target surface 270 of the SiC single-crystalline substrate 200 and the bonding target surface 770 of the second SiC polycrystalline substrate 700 were brought into contact with each other in a vacuum state in the chamber 400 to be directly bonded by covalent bonds, thereby obtaining a bonded substrate.

The second normal temperature bonding step was also performed in the same manner for the composite substrate 101 for transferring a SiC single crystal of Example 2, the composite substrate for transferring a SiC single crystal of Comparative Example 1, and the SiC single-crystalline substrate 200 of Comparative Example 2 to obtain a bonded substrate.

### (Peeling Step (S8))

The bonded substrate was heated using a furnace to 1100°C in an inert atmosphere filled with an argon gas to form a microbubble layer in the hydrogen ion implantation layer 600, the SiC single-crystalline substrate 200 was separated by the microbubble layer, and the thin SiC single-crystalline thin film 280 having a thickness of 0.8 µm was transferred to the second SiC polycrystalline substrate 700 to obtain the SiC bonded substrate 800 (Fig. 9).

The peeling step was also performed in the same manner for the bonded substrates in the composite substrate 101 for transferring a SiC single crystal of Example 2, the composite substrate for transferring a SiC single crystal of Comparative Example 1, and the SiC single-crystalline substrate 200 of Comparative Example 2 to obtain a SiC bonded substrate.

### [Evaluation 1: Evaluation of Conveyability]

By repeatedly using the composite substrate 100 for transferring a SiC single crystal after the peeling step, the steps S4 to S10 were repeatedly performed to repeatedly manufacture the SiC bonded substrate 800. Note that the second bonding target surface polishing step (S8) was performed as follows.

### (Second Bonding Target Surface Polishing Step (S8))

For the composite substrate 100 for transferring a SiC single crystal after the peeling step, the second bonding target surface 270 was mirror-polished by a CMP method before the hydrogen ion implantation layer forming step. The composite substrate 101 for transferring a SiC single crystal of Example 2, the composite substrate for transferring a SiC single crystal of Comparative Example 1, and the SiC single-crystalline substrate 200 of Comparative Example 2 after the peeling step were also mirror-polished in the same manner.

### <Results>

### (Composite Substrates 100 and 101 for Transferring SiC Single Crystal of Examples 1 and 2)

In the composite substrates 100 and 101 for transferring a SiC single crystal of Examples 1 and 2, since the warpage of the substrate due to hydrogen ion implantation was suppressed to 320 µm or less even when the thickness of the SiC single-crystalline substrate 200 was reduced from the initial thickness of 350 µm to 140 µm by transfer, errors in conveying the composite substrates 100 and 101 for transferring a SiC single crystal, and the like did not occur when the composite substrates 100 and 101 for transferring a SiC single crystal were conveyed.

### (Composite substrate for Transferring SiC Single Crystal of Comparative Example 1)

Since the warpage of the substrate was suppressed to 320 µm or less even when the thickness of the SiC single-crystalline substrate 200 was reduced from the initial thickness of 350 µm to 140 µm by transfer, errors in conveying the composite substrate for transferring a SiC single crystal, and the like did not occur when the composite substrate for transferring a SiC single crystal was conveyed.

### (SiC Single-Crystalline Substrate 200 of Comparative Example 2)

Since the SiC single-crystalline substrate 200 was not bonded to the first SiC polycrystalline substrate 300, when the thickness of the SiC single-crystalline substrate 200 was reduced from the initial thickness of 350 µm to less than 300 µm by transfer, the warpage of the substrate exceeded 1000 µm, so that errors in conveying the SiC single-crystalline substrate 200 occurred.

From the above results, it was found that since the composite substrates 100 and 101 for transferring a SiC single crystal of Examples 1 and 2 can be further repeatedly used for manufacturing the SiC bonded substrate 800 as compared with the SiC single-crystalline substrate 200 of Comparative Example 2, the loss of the SiC single-crystalline substrate 200 can be reduced, and the manufacturing efficiency of the SiC bonded substrate 800 can be increased.

### [Evaluation 2: Bondability between SiC Single-Crystalline Thin Film 280 and Second SiC Polycrystalline Substrate 700]

The bonding defects between the SiC single-crystalline thin film 280 and the second SiC polycrystalline substrate 700 were analyzed using a SiC wafer defect inspection apparatus SICA88 manufactured by Lasertec Corporation.

As a result, in the case of using the composite substrate 101 for transferring a SiC single crystal of Example 2, the generation of dust could be suppressed by eliminating the recess 111, and the volume resistivity of the first SiC polycrystalline substrate 300 was 3 Ω·cm, so that polishing debris, polishing powder, or the like was less likely to adhere to the first SiC polycrystalline substrate 300, and as a result, bonding defects could be suppressed by 80% as compared with the case of using the SiC single-crystalline substrate 200 of Comparative Example 1.

In the case of using the composite substrate 100 for transferring a SiC single crystal of Example 1, the volume resistivity of the first SiC polycrystalline substrate 300 was 3 Ω·cm, so that polishing debris, polishing powder, or the like was less likely to adhere to the first SiC polycrystalline substrate 300, and as a result, bonding defects could be suppressed by 50% as compared with the case of using the SiC single-crystalline substrate 200 of Comparative Example 1.

In the case of using the composite substrate for transferring a SiC single crystal of Comparative Example 1, the recess 111 was present, and the volume resistivity of the first SiC polycrystalline substrate was 100 Ω·cm, which had high insulating property, so that polishing debris, polishing powder, or the like was likely to adhere to the first SiC polycrystalline substrate, and bonding defects could not be suppressed.

### Reference Signs List

- 100, 101, 102, 103: composite substrate for transferring
- SiC: single crystal
- 110: contour
- 111: recess
- 112: side surface
- 113: side surface
- 114: side surface
- 120: bonding surface
- 200: SiC single-crystalline substrate
- 201: one surface
- 260: first bonding target surface
- 270: second bonding target surface
- 280: SiC single-crystalline thin film
- 300: first SiC polycrystalline substrate
- 301: one surface
- 310: slope
- 320: back side surface
- 330: end
- 350: contour line
- 360: bonding target surface
- 400: chamber
- 410: FAB gun
- 411: neutral element beam
- 500: electrostatic chuck
- 600: hydrogen ion implantation layer
- 700: second SiC polycrystalline substrate
- 770: bonding target surface
- 800: SiC bonded substrate
- 900: doping layer
- A: angle
- B: angle

## Claims

1. A composite substrate for transferring a SiC single crystal, comprising:
a SiC single-crystalline substrate; and
a first SiC polycrystalline substrate having a volume resistivity of 10 Ω·cm or less, wherein
one surface of the SiC single-crystalline substrate is directly bonded to one surface of the first SiC polycrystalline substrate by covalent bonds.

2. The composite substrate for transferring a SiC single crystal according to claim 1, wherein the first SiC polycrystalline substrate has a wafer shape, and a maximum value of a contour line of a circumference of the first SiC polycrystalline substrate is identical to a contour line of a circumference of a bonding surface between the SiC single-crystalline substrate and the first SiC polycrystalline substrate.

3. A method for manufacturing the composite substrate for transferring a SiC single crystal according to claim 1, the method comprising:
a first activation step of irradiating a first bonding target surface of the SiC single-crystalline substrate and a bonding target surface of the first SiC polycrystalline substrate with a fast atomic beam to activate these bonding target surfaces; and
a first normal temperature bonding step of bonding the first bonding target surface of the SiC single-crystalline substrate and the bonding target surface of the first SiC polycrystalline substrate to each other at normal temperature such that these bonding target surfaces are directly bonded to each other by covalent bonds, after the first activation step.

4. The method for manufacturing the composite substrate for transferring a SiC single crystal according to claim 3, comprising a side surface polishing step of polishing a side surface of the first SiC polycrystalline substrate to remove a side surface of the SiC single-crystalline substrate, a side surface of the first SiC polycrystalline substrate, and a recess formed by a contour of a circumference of a bonding surface between the SiC single-crystalline substrate and the first SiC polycrystalline substrate, after the first normal temperature bonding step.

5. A method for manufacturing a SiC bonded substrate, the method comprising:
a hydrogen ion implantation layer forming step of implanting hydrogen ions into a second bonding target surface of the SiC single-crystalline substrate in the composite substrate for transferring a SiC single crystal according to claim 1 to form a hydrogen ion implantation layer inside the SiC single-crystalline substrate;
a second activation step of irradiating the second bonding target surface of the SiC single-crystalline substrate and a bonding target surface of a second SiC polycrystalline substrate with a fast atomic beam to activate these bonding target surfaces;
a second normal temperature bonding step of bonding the second bonding target surface of the SiC single-crystalline substrate and the bonding target surface of the second SiC polycrystalline substrate at normal temperature such that these bonding target surfaces are directly bonded to each other by covalent bonds, after the second activation step; and
a peeling step of peeling the SiC single-crystalline substrate along the hydrogen ion implantation layer to transfer a SiC single-crystalline thin film to the second SiC polycrystalline substrate, after the second normal temperature bonding step, wherein
the composite substrate for transferring a SiC single crystal and the second SiC polycrystalline substrate are held by an electrostatic chuck, the SiC bonded substrate including the SiC single-crystalline thin film on the second SiC polycrystalline substrate.

6. The method for manufacturing a SiC bonded substrate according to claim 5, the method repeatedly using the composite substrate for transferring a SiC single crystal after the peeling step to manufacture a plurality of the SiC bonded substrates, wherein
the hydrogen ion implantation layer forming step, the second activation step, the second normal temperature bonding step, and the peeling step are repeated until a thickness of the SiC single-crystalline substrate of the composite substrate for transferring a SiC single crystal is less than 140 µm.
